# EUROPÄISCHE PATENTSCHRIFT

(11) **EP 2 478 550 B1**
(45) Veröffentlichungstag und Bekanntmachung des Hinweises auf die Patenterteilung: **21.01.2015**
(21) Anmeldenummer: 10752822.6
(22) Anmeldetag: 14.09.2010
(51) Int. Cl.: H01L 21/67

(54) **ABZIEHROLLE, VORRICHTUNG UND VERFAHREN ZUM ABLÖSEN EINER FOLIE VON EINEM SCHEIBENFÖRMIGEN WERKSTÜCK**
PINCH ROLL, DEVICE, AND METHOD FOR REMOVING A FILM FROM A DISC-SHAPED WORKPIECE
ROULEAU DE DÉCOLLEMENT, DISPOSITIF ET PROCÉDÉ PERMETTANT LE DÉCOLLEMENT D'UN FILM D'UNE PIÈCE EN FORME DE DISQUE

(30) Priorität: 15.09.2009 DE 102009041294
(43) Veröffentlichungstag der Anmeldung: 25.07.2012
(73) Patentinhaber: ERS electronic GmbH, 82110 Germering (DE)
(72) Erfinder: SCHINDLER, Rüdiger, 96465 Neustadt - Birkig (DE)
(74) Vertreter: Isarpatent
(86) Internationale Anmeldenummer: PCT/EP2010/063486
(87) Internationale Veröffentlichungsnummer: WO 2011/032947

(56) Entgegenhaltungen:
- EP-A2- 1 777 734
- WO-A1-02/32667
- DE-U1-202008 002 116
- GB-A- 1 557 043
- JP-A- 6 072 624
- JP-A- 2009 010 155
- US-A1- 2005 065 634
- US-A1- 2008 017 311
- US-A1- 2008 308 221
- US-A1- 2009 107 633
- US-B1- 6 500 298

## Beschreibung

Die vorliegend Erfindung betrifft eine Vorrichtung und ein Verfahren zum Ablösen einer Folie von einem scheibenförmigen Werkstück, insbesondere einem Mould-Wafer.

Aus der JP 2009/010155 A ist eine Vorrichtung zum Ablösen einer Folie von einem scheibenförmigen Werkstück mit einer Festspanneinrichtung zum kraftschlüssigen Festspannen der scheibenförmigen Werkzeuges und einer Abziehrolle bekannt. Die Abziehrolle weißt einen Folienmanipulierabschnitt zum kraftschlüssigen Aufnehmen eines Abschnitts der Folie, eine Verfahreinrichtung zum Verfahren der Abziehrolle horizontal zur einer Oberfläche der Festspannvorrichtung und eine Rotiereinrichtung zum Rotieren der Abziehrolle um eine Mittelachse der Abziehrolle auf.

Obwohl auf beliebige scheibenförmige Werkstücke anwendbar, werden die vorliegende Erfindung und die ihr zugrunde liegende Problematik in Bezug auf einen Mold-Wafer näher erläutert.

Die erfindungsgemäße Vorrichtung ist insbesondere in einer Wafer-Fertigungslinie angeordnet und dient der Ablösung und Trennung einer Folie von einem scheibenförmigen Werkstück, insbesondere von einem Mold-Wafer oder Compound-Wafer. Ein Mold-Wafer oder Compound-Wafer ist ein zusammengesetzter Wafer, der durch das Zusammensetzen einzelner Chips, beispielsweise Siliziumchips, zu einem waferförmigen Gebilde erzeugt wird, wobei die Chips mittels einem Kunststoffmaterial zu einer scheibenförmigen Struktur verklebt werden. Im Rahmen vielfältiger Arbeitsschritte zur Herstellung eines derartigen Wafers werden auf scheiberiförmige Werkstücke Folien aufgebracht, insbesondere aufgeklebt oder mittels einer Adhäsionswirkung haftend angebracht. Diese Folien besitzen eine Selbstklebeeigenschaft. Die Folien dienen beispielsweise als Schutz- und Abdeckfolien während einzelner Verarbeitungsschritte, können jedoch auch funktional für die Verarbeitung der Werkstücke wichtig sein, beispielsweise zur Fixierung einzelner Werkstückteile oder als zweiseitiger Klebeträger zur haftenden Behandlung und zum Transport des Werkstücks mittels Werkzeugmaschinen.

Vor der Fertigstellung des Mold-Wafers ergibt sich insbesondere in einem fließbandartigen Verarbeitungsverfahren die Notwendigkeit der möglichst schonenden, zuverlässigen und rückstandsfreien Ablösung der Folie von dem Mold-Wafer, insbesondere mit hoher Geschwindigkeit und großer Zuverlässigkeit.

Diese Aufgabe wird gelöst durch eine Abziehrolle mit den Merkmalen des Patentanspruchs 1 und/oder durch eine Vorrichtung mit den Merkmalen des Patentanspruchs 4 und/oder durch ein Verfahren mit den Merkmalen des Patentanspruchs 9.

Demgemäß sind vorgesehen:
Eine Vorrichtung zum Ablösen einer Folie von einem scheibenförmigen Werkstück, insbesondere einem Compound-Wafer, mit den Merkmalen des unabhängigen Anspruchs 1.

Ein Verfahren zum Ablösen einer Folie von einem scheibenförmigen Werkstück, insbesondere einem Compound-Wafer, mittels einer derartigen Vorrichtung, mit den Schritten des unabhängigen Anspruchs 8.

Dabei wird die Folie, insbesondere ein Abschnitt der Folie, mittels des Folienmanipulierabschnittes der Abziehrolle an dieser angehaftet. Mittels horizontalen und vertikalem Verfahren der Abziehrolle relativ zu dem scheibenförmigen Werkstück wird die Folie schnell und rückstandsfrei automatisiert von dem scheibenförmigen Werkstück abgelöst.

Vorteilhafte Ausgestaltungen und Weiterbildungen der vorliegenden Erfindung ergeben sich aus den Unteransprüchen und aus der Beschreibung in Zusammenschau mit den Figuren der Zeichnungen.

Gemäß einer bevorzugten Weiterbildung der Vorrichtung weist die Verfahreinrichtung ein horizontales Verfahrelement zum Verfahren der Abziehrolle horizontal zu der Oberfläche der Festspanneinrichtung und ein vertikales Verfahrelement zum Verfahren der Abziehrolle vertikal zu der Oberfläche der Festspanneinrichtung auf. Hierdurch ist ein schnelles und exaktes Positionieren der Abziehrolle relativ zu dem scheibenförmigen Werkstück möglich.

Gemäß einer weiteren bevorzugten Weiterbildung der Vorrichtung weist diese eine Heizeinrichtung zum Aufheizen des scheibenförmigen Werkstückes und/oder der Folie auf eine vorbestimmte Temperatur, insbesondere auf eine Temperatur zwischen 180°C und 240°C auf, wodurch ein zuverlässiges Ablösen der Folie von dem scheibenförmigen Werkstück gewährleistet ist.

Gemäß einer weiteren bevorzugten Weiterbildung der Vorrichtung weist die Festspanneinrichtung ein Antriebselement zum Verdrehen einer Werkstückaufnahme der Festspanneinrichtung um eine Drehachse der Werkstückaufnahme auf. Dies ermöglicht ein Verdrehen der Werkstückaufnahme vor dem Abziehen der Folie, wodurch vorteilhaft ein Ablösewinkel der Folie von dem scheibenförmigen Werkstück einstellbar ist. Dies erleichtert das Abziehen der Folie von dem scheibenförmigen Werkstück.

Gemäß einer weiteren bevorzugten Weiterbildung der Vorrichtung weist diese eine Anblaseinrichtung zum Anblasen eines über das scheibenförmige Werkstück hinausragenden Abschnittes der Folie auf, wobei die Anblaseinrichtung derart ausgebildet ist, dass diese den hinausragenden Abschnitt in Richtung der Abziehrolle bläst. Hierdurch wird ein zuverlässiges Aufnehmen des Abschnittes von der Abziehrolle gewährleistet, wodurch die Zuverlässigkeit der Vorrichtung erhöht wird.

Gemäß einer bevorzugten Weiterbildung des Verfahrens gehen das Rotieren, das vertikale Verfahren und das horizontale Verfahren der Abziehrolle derart ineinander über, dass die Folie ruckfrei von dem scheibenförmigen Werkstück abgelöst wird. Hierdurch wird zuverlässig verhindert, dass Reste der Folie an dem scheibenförmigen Werkstück verbleiben oder das scheibenförmige Werkstück beschädigt wird.

Gemäß einer weiteren bevorzugten Weiterbildung des Verfahrens wird die Folie bei einer vorbestimmten Temperatur, insbesondere bei einer Temperatur von 180°C bis 240°C, von dem scheibenförmigen Werkstück abgelöst. Hierdurch ist ein einfaches und vollständiges Ablösen der Folie von dem scheibenförmigen Werkstück gewährleistet.

Gemäß einer weiteren bevorzugten Weiterbildung des Verfahrens wird ein über das scheibenförmige Werkstück hinausragender Abschnitt der Folie mittels einer Anblaseinrichtung zum Anhaften des Abschnittes der Folie an der Abziehrolle in Richtung der Abziehrolle geblasen. Hierdurch wird ein störungsfreies Aufnehmen des Abschnittes der Folie von der Abziehrolle gewährleistet, wodurch sich die Zuverlässigkeit des Verfahrens erhöht.

Gemäß einer weiteren bevorzugten Weiterbildung des Verfahrens wird als Umschlingungswinkel ein Winkel von 180° gewählt. Hierdurch wird zuverlässig ein Abrutschen des Abschnittes der Folie von der Abziehrolle gewährleistet.

Gemäß einer weiteren bevorzugten Weiterbildung des Verfahrens wird die Werkstückaufnahme der Festspanneinrichtung vor dem Abziehen der Folie um einen Abziehwinkel verdreht. Hierdurch ist vorteilhaft ein Ablösewinkel der Folie von dem scheibenförmigen Werkstück einstellbar, wodurch das Ablösen der Folie von dem scheibenförmigen Werkstück erleichtert und beschleunigt wird.

Gemäß einer weiter bevorzugten Weiterbildung des Verfahrens wird das Abstoßen der Folie von der Abziehrolle in eine Folienentsorgungseinrichtung mittels eines Abstoßsensors, insbesondere eines Lichtgitters, der Folienentsorgungseinrichtung überwacht. Hierdurch ist zuverlässig eine von der Abziehrolle nicht abgelöste Folie zuverlässig detektierbar, wodurch sich die Störungsanfälligkeit des Verfahrens reduziert.

Die Erfindung wird im Folgenden anhand von Ausführungsbeispielen unter Bezugnahme auf die beiliegenden Figuren der Zeichnung näher erläutert.

Von den Figuren zeigen:
- Fig. 1: eine perspektivische Ansicht einer Vorrichtung gemäß einer bevorzugten Ausführungsform der vorliegenden Erfindung;
- Fig. 2: eine Schnittansicht der Vorrichtung nach Fig. 1;
- Fig. 3A: eine Aufsicht einer Abziehrolle zur Verwendung einer bevorzugten Ausführungsform der vorliegenden Erfindung;
- Fig. 3B: eine Aufsicht einer Abziehrolle zur Verwendung einer weiteren bevorzugten Ausführungsform der vorliegenden Erfindung;
- Fig. 4: eine Schnittansicht der Abziehrolle gemäß der Schnittlinie IV-IV nach Fig. 3A;
- Fig. 5: eine Flussdiagrammdarstellung eines Verfahrens gemäß einer bevorzugten Ausführungsform der vorliegenden Erfindung;
- Fig. 6: eine Schnittansicht der Vorrichtung nach Fig. 1 bei der Durchführung eines Verfahrensschrittes des Verfahrens nach Fig. 5;
- Fig. 7: eine Schnittansicht der Vorrichtung nach Fig. 1 bei der Durchführung eines weiteren Verfahrensschrittes des Verfahrens nach Fig. 5;
- Fig. 8: eine Schnittansicht der Vorrichtung nach Fig. 1 bei der Durchführung eines noch weiteren Verfahrensschrittes des Verfahrens nach Fig. 5;
- Fig. 9: eine Schnittansicht der Vorrichtung nach Fig. 1 bei der Durchführung eines noch weiteren Verfahrensschrittes des Verfahrens nach Fig. 5;
- Fig. 10: eine Schnittansicht der Vorrichtung nach Fig. 1 bei der Durchführung eines noch weiteren Verfahrensschrittes des Verfahrens nach Fig. 5;
- Fig. 11: eine Schnittansicht der Vorrichtung nach Fig. 1 bei der Durchführung eines noch weiteren Verfahrensschrittes des Verfahrens nach Fig. 5;
- Fig. 12: eine Schnittansicht der Vorrichtung nach Fig. 1 bei der Durchführung eines noch weiteren Verfahrensschrittes des Verfahrens nach Fig. 5; und
- Fig. 13: eine Draufsicht der Vorrichtung nach Fig. 1 bei der Durchführung eines noch weiteren Verfahrensschrittes des Verfahrens nach Fig. 5.

In den Figuren bezeichnen gleiche Bezugszeichen gleiche oder funktionsgleiche Komponenten, soweit nichts Gegenteiliges angegeben ist.

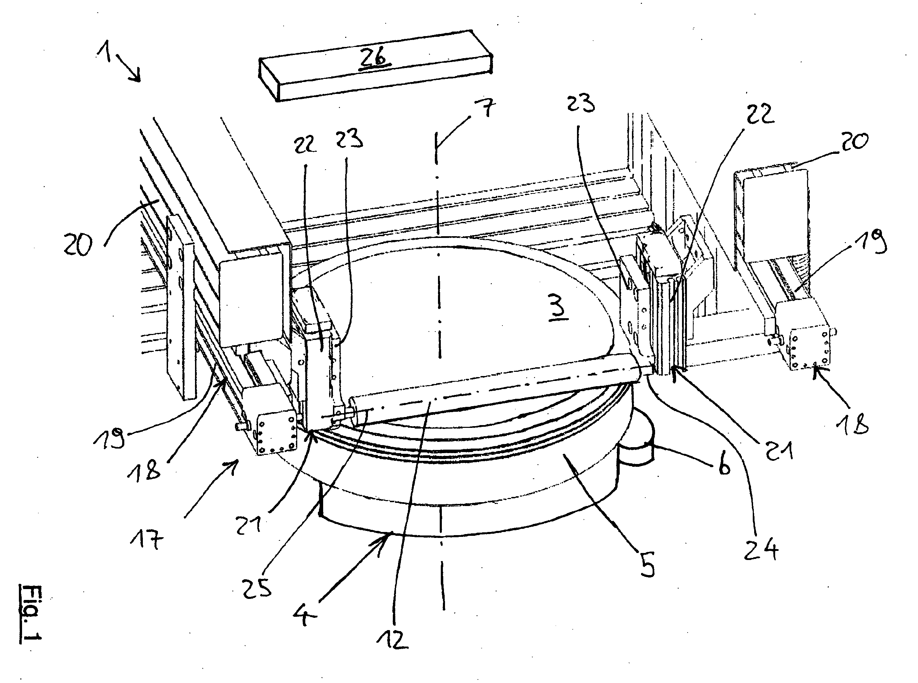

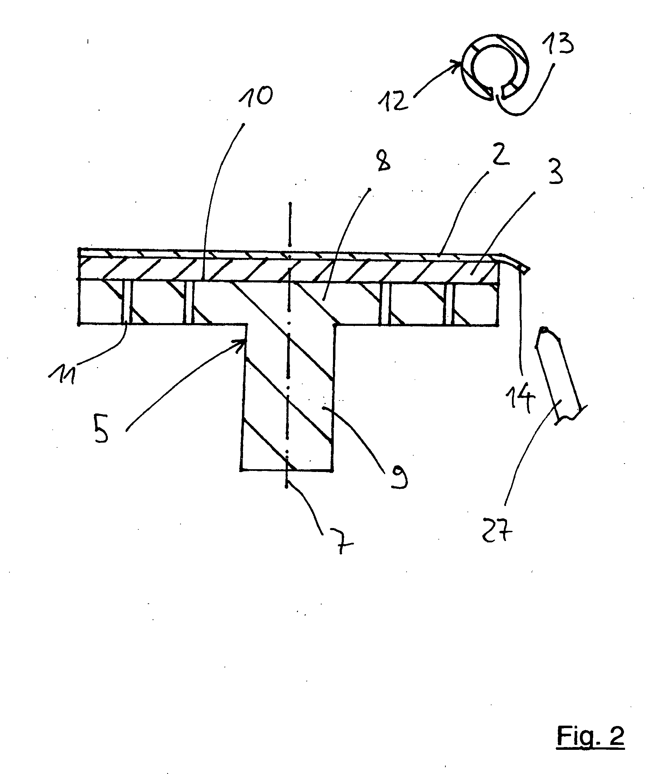

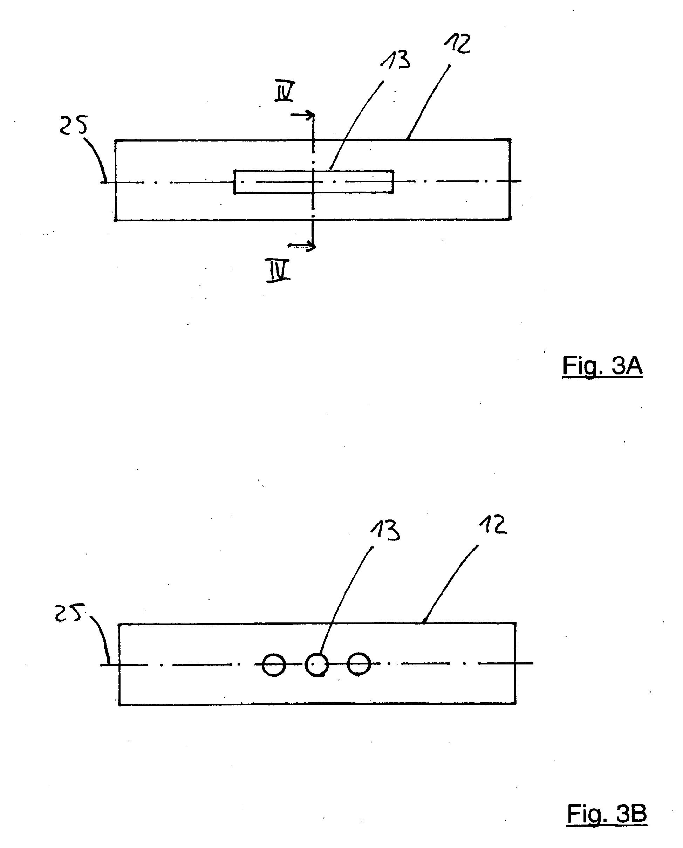

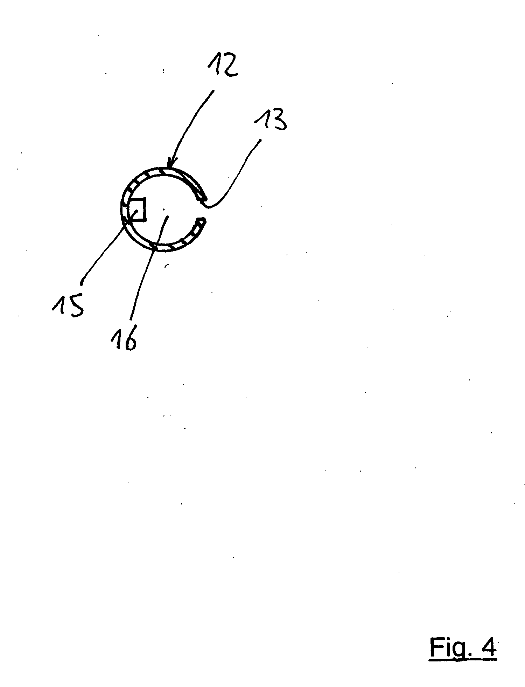

Die Fig. 1 illustriert eine perspektivische Ansicht einer Vorrichtung 1 zum Abziehen bzw. Ablösen einer Folie 2 von einem scheibenförmigen Werkstück 3, insbesondere einem Compound-Wafer 3 oder einem Mold-Wafer 3. Die Fig. 2 illustriert die Vorrichtung 1 nach Fig. 1 in einer Schnittansicht. Die Fig. 3 und 4 illustrieren eine Abziehrolle 12 der Vorrichtung 1 in einer Aufsicht bzw. in einer Schnittansicht. Im Folgenden wird auf die Fig. 1 bis 4 gleichzeitig Bezug genommen. Die Vorrichtung 1 weist vorzugsweise eine Festspanneinrichtung 4 zum kraftschlüssigen Festspannen des scheibenförmigen Werkstücks 3 auf einer Oberfläche 10 der Festspanneinrichtung 4 auf. Die Festspanneinrichtung 4 weist vorzugsweise eine Werkstückaufnahme 5 auf, welche beispielsweise mittels eines Antriebselementes 6 um eine Drehachse 7 der Werkstückaufnahme 5 rotierbar ist. Die Werkstückaufnahme 5 weist im Wesentlichen einen tellerförmigen Werkstückauflageabschnitt 8 und einen sich aus dem Werkstückauflageabschnitt 8 erstreckenden zylinderförmigen Schaftabschnitt 9 auf. Der Werkstückauflageabschnitt 8 weist die Oberfläche 10 auf, auf welcher das scheibenförmige Werkstück 3 angeordnet ist. Das scheibenförmige Werkstück 3 ist beispielsweise mittels eines Vakuums an der Festspanneinrichtung 4 kraftschlüssig festgelegt. Hierzu weist der Werkstückauflageabschnitt 8 beispielsweise eine Vielzahl an Vakuumbohrungen 11 auf, von denen nur eine mit einem Bezugszeichen versehen ist, mittels welcher das scheibenförmige Werkstück 3 an die Oberfläche 10 der Festspanneinrichtung 4 angesaugt ist. Die Vakuumbohrungen 11 sind vorzugsweise mit einer nicht dargestellten Vakuumeinrichtung der Vorrichtung 1 wirkverbunden. Der Schaftabschnitt 9 erstreckt sich bevorzugt aus einer der Oberfläche 10 abgewandten Oberfläche des Werkstückauflageabschnittes 8.

Die Vorrichtung 1 weist weiterhin eine Abziehrolle 12 auf, welche beispielsweise in Form eines Hohlzylinders mit einer Mittelachse 25 ausgebildet ist. Die Abziehrolle 12 weist vorzugsweise einen Folienmanipulierabschnitt 13 auf, welcher zum kraftschlüssigen Aufnehmen oder zum Abstoßen der Folie 2, insbesondere eines Abschnittes 14 der Folie 2 ausgebildet ist. Der Abschnitt 14 der Folie 2 ist beispielsweise ein Endabschnitt 14 oder ein Randabschnitt 14 der Folie 2. Der Abschnitt 14 der Folie 2 kann beispielsweise seitlich über das scheibenförmige Werkstück 3 und/oder die Werkstückaufnahme 5 hinausragen. Der Folienmanipulierabschnitt 13 ist vorzugsweise als schaltbarer Unterdruck-Überdruckabschnitt 13 ausgebildet. Alternativ kann der Folienmanipulierabschnitt 13 als Klemmeinrichtung mit einem Klemmgreifer zum Greifen der Folie 2 ausgebildet sein. Beispielsweise ist der Folienmanipulierabschnitt 13, wie in Fig. 3A illustriert, als entlang der Mittelachse 25 der Abziehrolle 12 angeordneter Saug/Blasschlitz 13 ausgebildet. Alternativ oder zusätzlich kann der Folienmanipulierabschnitt 13 gemäß Fig. 3B als Saug/Blasdüse 13 oder als eine Vielzahl an Saug-/Blasdüsen 13 ausgebildet sein. Der Folienmanipulierabschnitt 13 ist wahlweise zum kraftschlüssigen Aufnehmen der Folie 2, insbesondere des Abschnittes 14 der Folie 2, mittels einem Unterdruck oder zum Abstoßen der Folie 2, insbesondere des Abschnittes 14, von der Abziehrolle 12 mittels einem Überdruck ausgebildet. Hierzu weist die Vorrichtung 1 beispielsweise eine nicht dargestellte Vakuum-/Überdruckeinrichtung auf. Mittels des Folienmanipulierabschnittes 13 ist somit sowohl wahlweise ein kraftschlüssiges Aufnehmen der Folie 2, insbesondere des Abschnittes 14 der Folie 2, als auch ein Abstoßen der Folie 2, insbesondere des Abschnittes 14 der Folie 2, von der Abziehrolle 12 gewährleistet. Die Abziehrolle 12 weist weiterhin vorzugsweise einen Anhaftsensor 15 auf, welcher beispielsweise als Vakuumschalter 15 ausgebildet ist. Der Anhaftsensor 15 ist beispielsweise in einem Innenraum 16 der Abziehrolle 12 angeordnet. Der Anhaftsensor 15 dient zum Feststellen des kraftschlüssigen Aufnehmens oder des Abstoßens der Folie 2, insbesondere des Abschnittes 14 der Folie 2, mittels des Folienmanipulierabschnittes 13.

Die Vorrichtung 1 weist ferner vorzugsweise eine Verfahreinrichtung 17 zum Verfahren der Abziehrolle 12 horizontal und/oder vertikal zu der Oberfläche 10 der Festspanneinrichtung 4. Die Verfahreinrichtung 17 weist vorzugsweise ein horizontales Verfahrelement 18 zum Verfahren der Abziehrolle 12 horizontal zu der Oberfläche 10 der Festspanneinrichtung 4 auf. Das horizontale Verfahrelement 18 weist beispielsweise ein Führungsprofil 19 auf, welches beispielsweise relativ zu einem feststehenden Rahmenprofil 20 der Vorrichtung 1 linear verschieblich ist. Eine lineare Verschiebung der Profile 19, 20 zueinander ist beispielsweise mittels eines Elektromotors verwirklicht. Die Vorrichtung 1 weist vorzugsweise zwei horizontale Verfahrelemente 18 auf, welche jeweils beidseitig an Endabschnitten der Abziehrolle 12 positioniert sind. Die Verfahreinrichtung 17 weist ferner vorzugsweise ein vertikales Verfahrelement 21 zum Verfahren der Abziehrolle 12 vertikal zu der Oberfläche 10 der Festspanneinrichtung 4 auf. Das vertikale Verfahrelement 21 weist beispielsweise einen entlang einem Führungsprofil 22 linear verschieblichen Gleitkörper 23 auf. Der Gleitkörper 23 ist beispielsweise mittels eines Elektromotors relativ zu dem Führungsprofil 22 verschiebbar. Das Führungsprofil 22 ist beispielsweise an dem Führungsprofil 19 des horizontalen Verfahrelementes 17 montiert. Vorzugsweise weist die Vorrichtung 1 zwei vertikale Verfahrelemente 21 auf, welche jeweils an den Endabschnitten der Abziehrolle 12 angeordnet sind. Die Abziehrolle 12 ist vorzugsweise in dem Gleitkörper 23 des vertikalen Verfahrelementes 21 um ihre Mittelachse 25 drehbar gelagert.

Die Vorrichtung 1 weist weiterhin vorzugsweise eine Rotiereinrichtung 24 zum Rotieren der Abziehrolle 12 um ihre Mittelachse 25 auf. Die Rotiereinrichtung 24 weist beispielsweise einen mit der Abziehrolle 12 gekoppelten Elektromotor auf. Der Elektromotor kann beispielsweise direkt oder über eine Getriebestufe, beispielsweise einen Riemenantrieb, mit der Abziehrolle 12 wirkverbunden sein.

Die Vorrichtung weist weiterhin vorzugsweise eine Heizeinrichtung 26 zum Aufheizen des scheibenförmigen Werkstückes 3 und/oder der Folie 2 auf eine vorbestimmte Temperatur auf. Die Folie 2 ist beispielsweise mit einer wärmeempfindlichen Klebeschicht versehen und mittels dieser an dem scheibenförmigen Werkstück 3 angehaftet. Die Heizeinrichtung 26 ist beispielsweise als Infrarotstrahler 26 oder als Heißluftgebläse 26 ausgebildet. Die Heizeinrichtung 26 kann beispielsweise integraler Bestandteil der Festspanneinrichtung 4 sein, beispielsweise kann die Heizeinrichtung 26 als in die Werkstückauflage 8 integrierte Heizschleife ausgebildet sein. Alternativ kann die Heizeinrichtung 26 beabstandet von der Festspanneinrichtung 4 angeordnet sein. Vorzugsweise dient die Heizeinrichtung 26 zum Aufheizen des scheibenförmigen Werkstückes und/oder der Folie auf eine Temperatur zwischen 180° und 240° Celsius.

Die Vorrichtung 1 weist weiterhin vorzugsweise eine Anblaseinrichtung 27 zum Anblasen eines über das scheibenförmige Werkstück 3 hinausragenden Abschnittes 14 der Folie 2 auf. Die Anblaseinrichtung 27 ist beispielsweise als Luftdüse 27 oder als eine Vielzahl an Luftdüsen 27 ausgebildet. Die Anblaseinrichtung 27 verformt den über das scheibenförmige Werkstück 3 hinausragenden Anschnitt 14 der Folie 2 derart, dass dieser in Richtung der Abziehrolle 12 gebogen wird. Die Anblaseinrichtung 27 kann beispielsweise in die Festspanneinrichtung 4 integriert sein.

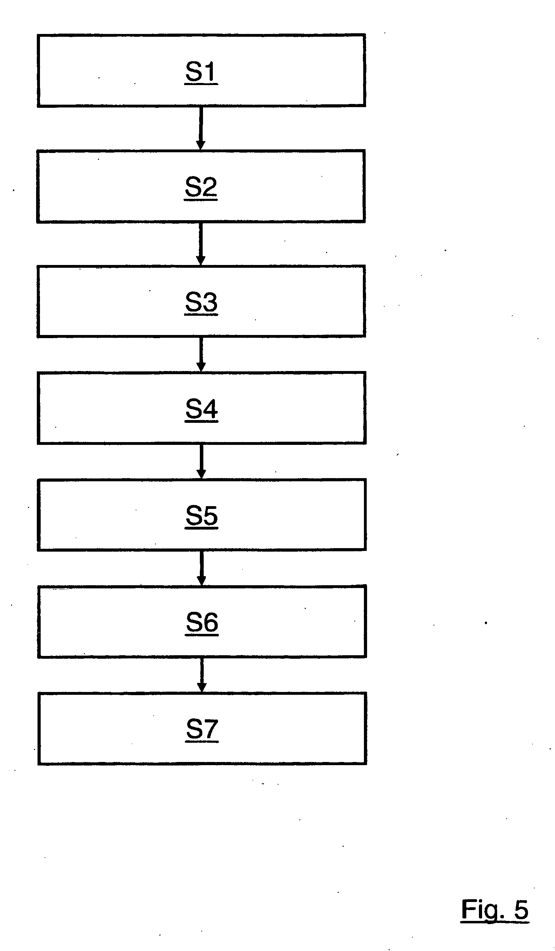

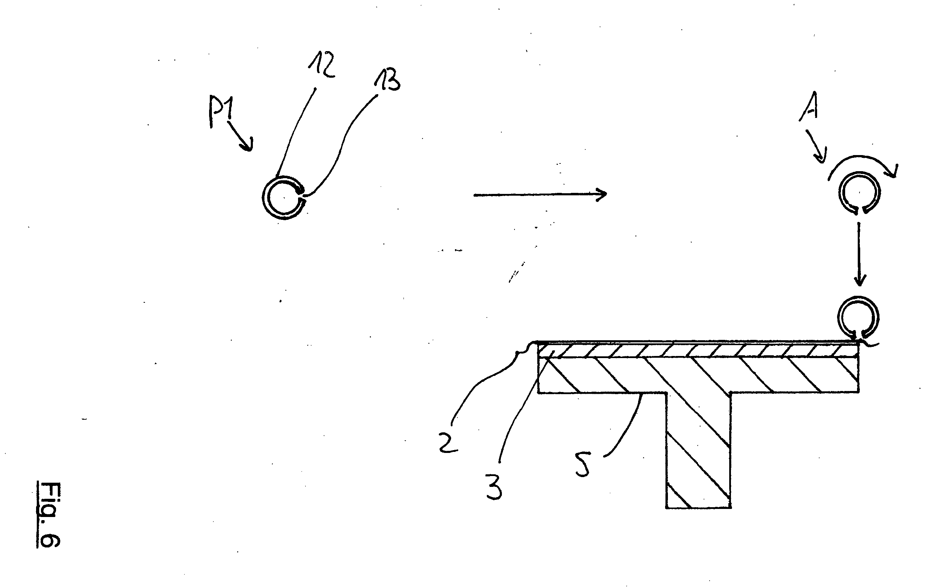

Die Fig. 5 bis 13, auf die im Folgenden gleichzeitig Bezug genommen wird, illustrieren ein Verfahren zum Ablösen der Folie 2 von dem scheibenförmigen Werkstück 3 mit einer derartigen Vorrichtung 1 gemäß der Fig. 1-4. In einem in Fig. 6 dargestellten Verfahrenschritt S1 erfolgt ein horizontales Verfahren der Abziehrolle 12 mittels der Verfahreinrichtung 17, insbesondere dem horizontalen Verfahrelement 18 der Verfahreinrichtung 17, von einer Parkposition P1 der Abziehrolle 12 in eine Aufnahmeposition A der Abziehrolle 12. In der Aufnahmeposition A ist der Folienmanipulierabschnitt 13 mittels der Rotiereinrichtung 24 der Folie 2 zugewandt. Der Verfahrensschritt S1 umfasst weiterhin vorzugsweise ein Aktivieren des Folienmanipulierabschnittes 13, beispielsweise das Zuschalten eines Vakuums und ein vertikales Absenken der Abziehrolle 12 auf die Folie 2 mittels der Verfahreinrichtung 17, insbesondere mittels dem vertikalen Verfahrelement 21 der Verfahreinrichtung 17. Die Aufnahmeposition ist beispielsweise mittels einer Softwareeinstellung einer Steuereinrichtung der Vorrichtung 1 einstellbar.

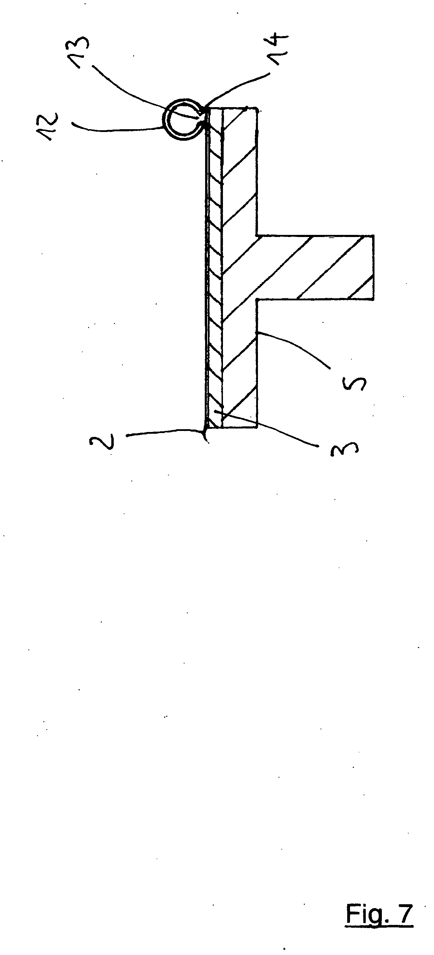

In einem Verfahrensschritt S2 gemäß Fig. 7 wird die Folie 2, insbesondere der Abschnitt 14 der Folie 2, mittels des Folienmanipulierabschnittes 13 an die Abziehrolle 12 angesaugt. Der Abschnitt 14 der Folie 2 haftet nun an der Abziehrolle 12. Der Verfahrenschritt S2 kann ein Anblasen des Abschnittes 14 der Folie 2 mittels der Anblaseinrichtung 27 umfassen, falls der Abschnitt 14 über das scheibenförmige Werkstück 3 hinausragt. Bei dem Anblasen wird der Abschnitt 14 zum Anhaften an der Abziehrolle 12 in Richtung der Abziehrolle 12 geblasen. Hierdurch wird die Aufnahme des Abschnittes 14 von dem Folienmanipulierabschnitt 13 erleichtert. Das Ansaugen der Folie 2 an die Abziehrolle 2 wird mittels des Anhaftsensors 15 überwacht.

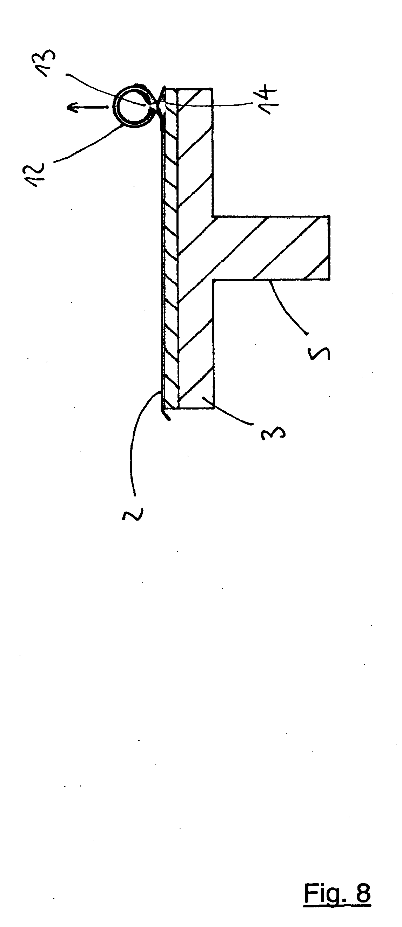

In einem Verfahrensschritt S3, welcher in Fig. 8 illustriert ist, wird die Abziehrolle 12 mittels der Verfahreinrichtung 17, insbesondere mittels dem vertikalen Verfahrelement 21 der Verfahreinrichtung 17, vertikal von dem scheibenförmigen Werkstück 3 abgehoben, wobei der Abschnitt 14 der Folie 2 zumindest abschnittsweise von dem scheibenförmigen Werkstück 3 getrennt wird. Vorzugsweise wird zuvor die Folie 2 und/oder das scheibenförmige Werkstück 3 mittels der Heizeinrichtung 26 zum Ablösen der Folie 2 auf eine vorbestimmte Temperatur erwärmt. Die Abziehrolle 12 wird zunächst soweit von dem scheibenförmigen Werkstück 3 abgehoben, dass gerade kein Kontakt der Abziehrolle 12 mit dem scheibenförmigen Werkstück 3 mehr besteht.

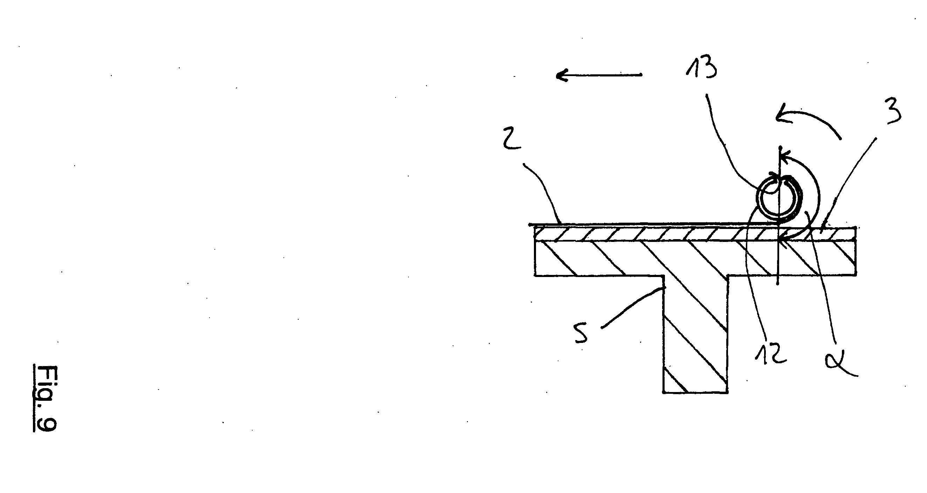

In einem Verfahrensschritt S4, dargestellt in Fig. 9, wird die Abziehrolle 12 mittels der Rotationseinrichtung 24 um einen vorbestimmten Umschlingungswinkel α rotiert und gleichzeitig mittels der Verfahreinrichtung 17 horizontal in Richtung der Parkposition P1 verfahren. Die Folie 2 wird dabei abschnittsweise auf der Abziehrolle 12 aufgewickelt. Der Umschlingungswinkel α beträgt vorzugsweise 180°, d.h. der Folienmanipulierabschnitt 13 ist dem scheibenförmigen Werkstück 3 nach dem Rotieren abgewandt. Gleichzeitig mit dem Rotieren der Abziehrolle 12 wird diese mittels der Verfahreinrichtung 17, insbesondere mittels dem horizontalen Verfahrelement 18, in Richtung der Parkposition P1 horizontal verfahren. Dabei wird die Folie 2 zunehmend von dem scheibenförmigen Werkstück 3 getrennt. Das Rotieren der Abziehrolle 12 und das gleichzeitige horizontale Verfahren erfolgen in einem vorgegebenen Verhältnis. Der Umschlingungswinkel α bzw. ein Umschlingungsradius der Folie 2 auf der Abziehrolle 12 ist beispielsweise über eine Softwareeinstellung an einer Steuereinrichtung der Vorrichtung 1 einstellbar. Der Verfahrensschritt S4 kann einen Zwischenschritt umfassen, bei dem die Abziehrolle 12 nach dem Rotieren um den Umschlingungswinkel α weiter horizontal bewegt wird und während ihrer horizontalen Linearbewegung in Richtung der Parkposition P1 um einen Sicherheitsabstand vertikal von dem scheibenförmigen Bauteil 3 abgehoben wird, um eine Kollision mit dem scheibenförmigen Bauteil 3 zu vermeiden.

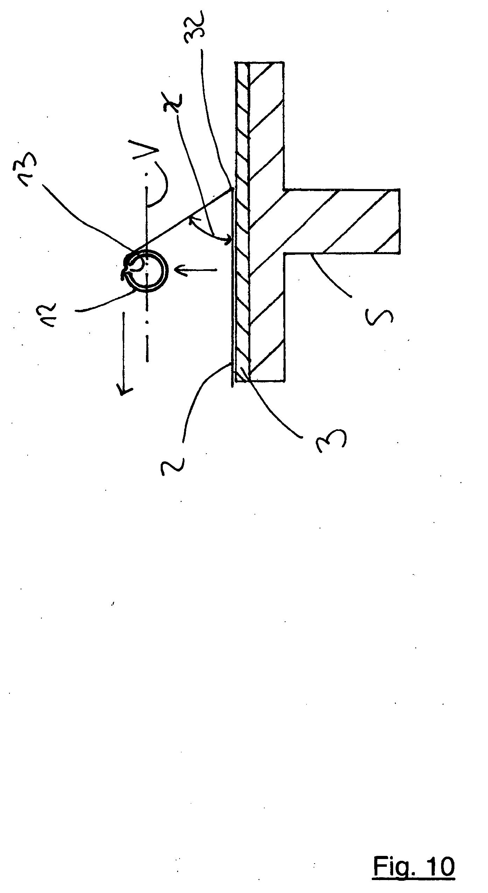

In einem Verfahrensschritt S5, dargestellt in Fig. 10, wird die Abziehrolle 12 mittels der Verfahreinrichtung 17 von dem scheibenförmigen Werkstück 3 weiter vertikal weggefahren und gleichzeitig weiter horizontal verfahren bis die Abziehrolle 12 eine vertikale Endposition V erreicht hat. Die vertikale Endposition V kann einer vertikalen Position der Parkposition P1 entsprechen. Nach dem Erreichen der vertikalen Endposition V wird die Abziehrolle 12 weiter in horizontal in Richtung der Parkposition P1 unter weiteren Ablösen der Folie 2 mit einem Ablösewinkel χ von dem scheibenförmigen Werkstück 3 verfahren. Der Ablösewinkel χ wird zwischen der Oberfläche 10 der Festspanneinrichtung 4 und der sich ablösenden Folie 2 bestimmt.

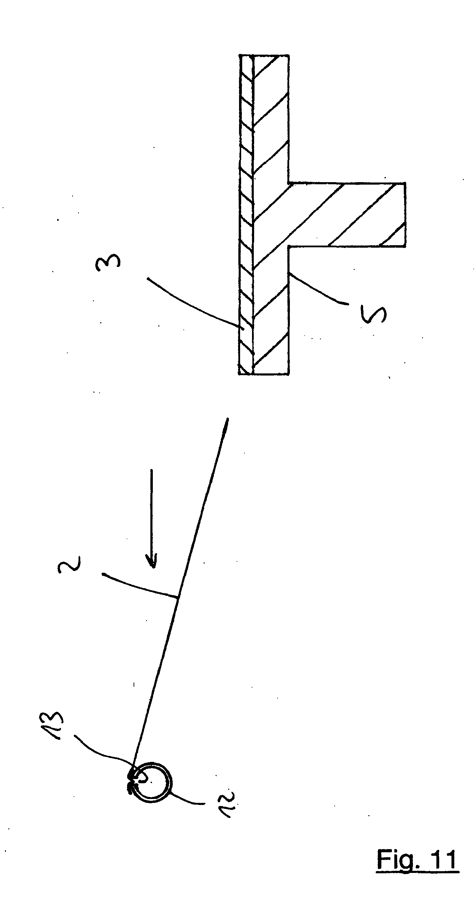

In einem Verfahrensschritt S6, welcher in Fig. 11 illustriert ist, wird die Abziehrolle 12 mittels der Verfahreinrichtung 17, insbesondere mittels dem horizontalen Verfahrelement 18 der Verfahreinrichtung 17, über die Parkposition P1 der Abziehrolle 12 hinaus in eine Abstoßposition P2 oder hinterste Parkposition P2 verfahren. Beim Erreichen der Abstoßposition P2 ist die Folie 2 vorzugsweise vollständig von dem scheibenförmigen Werkstück 3 abgetrennt. Bevorzugt greifen alle horizontalen, vertikalen und radialen Bewegungen der Abziehrolle 12 beim Abziehvorgang der Folie 2 von dem scheibenförmigen Werkstück 3 derart ineinander, dass ein gleichmäßiges Abziehverhalten der Folie 2 von dem scheibenförmigen Werkstück 3 gewährleistet ist und die Folie 2 ruckfrei von diesem abgezogen wird. Die Abziehrolle 12 folgt beim Ablösen der Folie 2 von dem scheibenförmigen Werkstück 3 vorzugsweise einer vordefinierten Bahnkurve. Die Bahnkurve wird beispielsweise mittels einer mechanischen Führung, insbesondere einer Kulissenführung, oder mittels einer entsprechenden Ansteuerung von Elektromotoren der Verfahreinrichtung 17 abgefahren. Horizontale, vertikale und radiale Bewegungsgeschwindigkeiten der Abziehrolle 12 sind bevorzugt derart angepasst, dass ein sanftes und ruckfreies Abziehen der Folie 2 von dem scheibenförmigen Werkstück 3 stets gewährleistet ist.

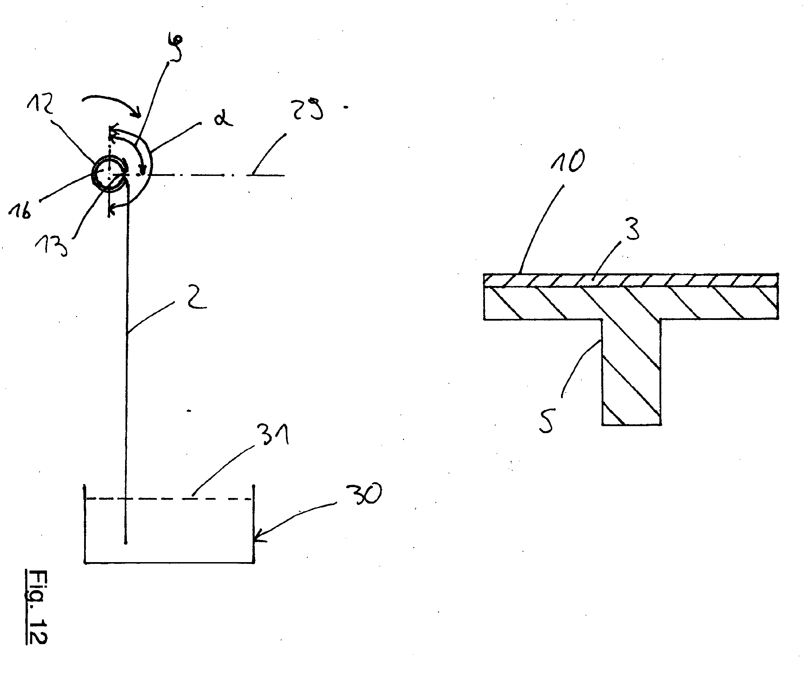

In einem Verfahrensschritt S7, illustriert in Fig. 12, wird der auf der Abziehrolle 12 aufgewickelte Abschnitt 14 der Folie 2 von der Abziehrolle 12 durch richtungsumgekehrtes Rotieren der Abziehrolle 12 mittels der Rotiereinrichtung 24 wieder abgewickelt. Die Abziehrolle 12 wird dabei um einen Winkelabschnitt ϕ des vorbestimmten Umschlingungswinkels α derart rotiert, dass der Folienmanipulierabschnitt 13 in einer Abwurfstellung positioniert ist. In der Abwurfstellung des Folienmanipulierabschnittes 13 ist eine Mittelachse 29 des Folienmanipulierabschnittes 13 vorzugsweise parallel zu der Oberfläche 10 der Festspanneinrichtung 4 ausgerichtet. Das im Innenraum 16 der Abziehrolle 12 herrschende Vakuum wird abgeschaltet und in dem Innenraum 16 der Abziehrolle 12 wird beispielsweise ein Überdruck derart aufgebaut, dass ein Druckstoß den Abschnitt 14 der Folie 2 aus dem Folienmanipulierabschnitt 13 bläst. Das ordnungsgemäße Abstoßen der Folie 2 von der Abziehrolle 12 wird mittels des Anhaftsensors 15 überwacht. Die Folie 2 wird vorzugsweise in einem Abfallbehälter einer Folienentsorgungseinrichtung 30 platziert, wobei das ordnungsgemäße Platzieren mittels eines Abstoßsensörs 31 der Folienentsorgungseinrichtung 30 überwacht wird. Der Abstoßsensor 31 ist insbesondere als Lichtgitter 31 ausgebildet. Nach dem Entfernen der Folie 2 von der Abziehrolle 12 kann diese wieder in ihre Parkposition P1 gefahren werden.

Wird die Folie 2 von der Abziehrolle 2 im Verfahrensschritt S2 nicht aufgenommen oder in einem der darauffolgenden Verfahrensschritte unbeabsichtigt von der Abziehrolle 12 getrennt, so wird diese Fehlfunktion mittels des Anhaftsensors 15 detektiert und die Vorrichtung gibt beispielsweise ein Störsignal auf. Ein Maschinenbediener kann dann beispielsweise die Folie 2 von Hand abziehen und den Störvorgang quittieren.

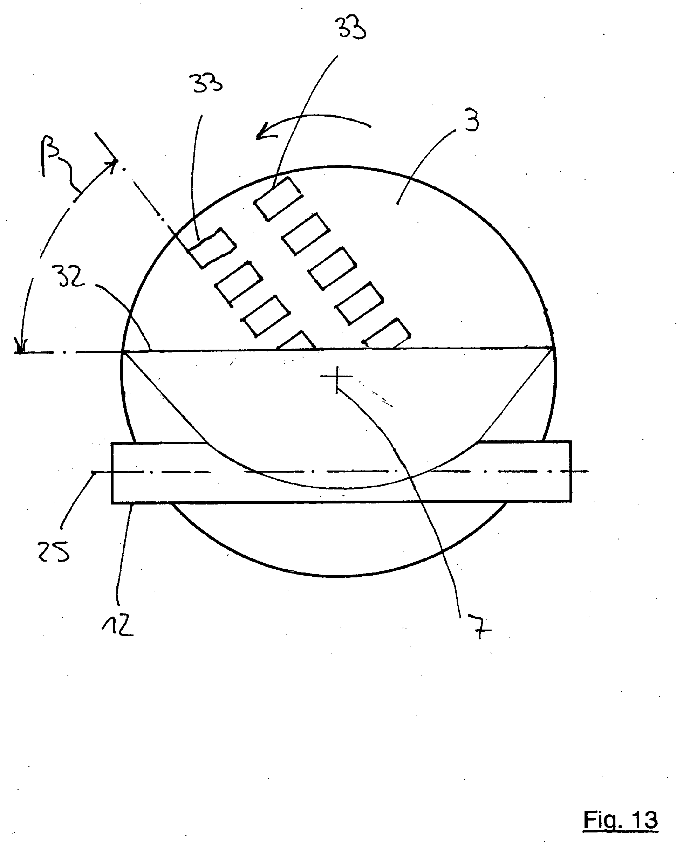

Vor dem Abziehen der Folie 2 von dem scheibenförmigen Werkstück 3 ist gemäß der Fig. 13 ein Abziehwinkel β zwischen einer Ablöskante 32 der sich von dem scheibenförmigen Werkstück 3 ablösenden Folie 2 und dem Scheibenförmigen Werkstück 3 mittels einem Verdrehen der Werkstückaufnahme 5 der Festspanneinrichtung 4 um deren Drehachse 7 einstellbar. Hierdurch wird die Folie 2 nicht gerade, sondern schräg von Chipbahnen 33 des scheibenförmigen Werkstück 3 abgezogen. Die Abziehrolle 12 verfährt dadurch nicht mehr orthogonal zu den Chipbahnen 33 sondern schräg. Ein Ruckeln beim Abziehen der Folie 2 wird unterbunden. Das Verdrehen der Werkstückaufnahme 5 kann beispielsweise vor dem Aufnehmen der Folie 2 erfolgen.

Obwohl die Vorrichtung 1 und das Verfahren zum Ablösen der Folie 2 mit der Heizeinrichtung 26 beschrieben wurden, ist die Heizeinrichtung 26 lediglich ein optionaler Bestandteil der Vorrichtung 1 und/oder des Verfahrens. Die Heizeinrichtung 26 ist verzichtbar. Der optionale Einsatz der Heizeinrichtung 26 ist beispielsweise abhängig von einer Art einer verwendeten Klebschicht zwischen der Folie 2 und dem scheibenförmigen Werkstück 3.

### Bezugszeichenliste

- 1: Vorrichtung
- 2: Folie
- 3: scheibenförmiges Werkstück
- 4: Festspanneinrichtung
- 5: Werkstückaufnahme
- 6: Antriebselement
- 7: Drehachse
- 8: Werkstückauflageabschnitt
- 9: Schaftabschnitt
- 10: Oberfläche
- 11: Vakuumbohrung
- 12: Abziehrolle
- 13: Folienmanipulierabschnitt
- 14: Abschnitt
- 15: Anhaftsensor
- 16: Innenraum
- 17: Verfahreinrichtung
- 18: horizontales Verfahrelement
- 19: Führungsprofil
- 20: Rahmenprofil
- 21: vertikales Verfahrelement
- 22: Führungsprofil
- 23: Gleitkörper
- 24: Rotiereinrichtung
- 25: Mittelachse
- 26: Heizeinrichtung
- 27: Anblaseinrichtung
- 29: Mittelachse
- 30: Folienentsorgungseinrichtung
- 31: Abstoßsensor
- 32: Ablöskante
- 33: Chipbahn
- A: Aufnahmeposition
- P1: Parkposition
- P2: Abstoßposition
- V: vertikale Endposition
- α: Umschlingungswinkel
- β: Abziehwinkel
- χ: Ablösewinkel
- ϕ: Winkelabschnitt

## Patentansprüche

1. Vorrichtung (1) zum Ablösen einer Folie (2) von einem scheibenförmigen Werkstück (3), insbesondere einem Mold-Wafer (3), mit:
einer Festspanneinrichtung (4) zum kraftschlüssigen Festspannen des scheibenförmigen Werkstücks (3);
einer Abziehrolle (12) mit einem Folienmanipulierabschnitt (13) zum kraftschlüssigen Aufnehmen oder zum Abstoßen eines Abschnittes (14) der Folie (2);
einer Verfahreinrichtung (17) zum Verfahren der Abziehrolle (12) horizontal und/oder vertikal zu einer Oberfläche (10) der Festspanneinrichtung (4); und
einer Rotiereinrichtung (24) zum Rotieren der Abziehrolle (12) um eine Mittelachse (25) der Abziehrolle (12), **dadurch gekennzeichnet, dass** der Folienmanipulierabschnitt (13) als schaltbarer Unterdruck-/ Überdruckabschnitt (13) ausgebildet ist.

2. Vorrichtung nach Anspruch 1,
**dadurch gekennzeichnet, dass**
die Verfahreinrichtung (17) ein horizontales Verfahrelement (18) zum Verfahren der Abziehrolle (12) horizontal zu der Oberfläche (10) der Festspanneinrichtung (4) und ein vertikales Verfahrelement (21) zum Verfahren der Abziehrolle (12) vertikal zu der Oberfläche (10) der Festspanneinrichtung (4) aufweist.

3. Vorrichtung nach Anspruch 1 oder 2,
**dadurch gekennzeichnet, dass**
die Vorrichtung (1) eine Heizeinrichtung (26) zum Aufheizen des scheibenförmigen Werkstückes (3) und/oder der Folie (2) auf eine vorbestimmte Temperatur, insbesondere auf eine Temperatur zwischen 180°C und 240°C, aufweist.

4. Vorrichtung nach einem der vorhergehenden Ansprüche,
**dadurch gekennzeichnet, dass** die Festspanneinrichtung (4) ein Antriebselement (6) zum Verdrehen einer Werkstückaufnahme (5) der Festspanneinrichtung (4) um eine Drehachse (7) der Werkstückaufnahme (5) aufweist.

5. Vorrichtung nach einem der vorhergehenden Ansprüche,
**dadurch gekennzeichnet, dass**
die Vorrichtung (1) eine Anblaseinrichtung (27) zum Anblasen eines über das scheibenförmige Werkstück (3) hinausragenden Abschnittes (14) der Folie (2) aufweist, wobei die Anblaseinrichtung (27) derart ausgebildet ist, dass diese den hinausragenden Abschnitt (14) in Richtung der Abziehrolle (12) bläst.

6. Vorrichtung nach einem der vorhergehenden Ansprüche,
**dadurch gekennzeichnet, dass**
der Folienmanipulierabschnitt (13) der Abziehrolle (12) als Saug-/Blasdüse (13) oder als entlang einer Mittelachse (25) der Abziehrolle (12) angeordneter Saug/Blasschlitz (13), zum kraftschlüssigen Aufnehmen des Abschnittes (14) der Folie (2) mittels einem Unterdruck oder zum Abstoßen des Abschnittes (14) der Folie (2) mittels einem Überdruck ausgebildet ist.

7. Vorrichtung nach einem der vorhergehenden Ansprüche,
**dadurch gekennzeichnet, dass**
die Abziehrolle (12) einen Anhaftsensor (15), insbesondere einen Vakuumschalter (15), zum Feststellen des kraftschlüssigen Aufnehmens oder des Abstoßens des Abschnittes (14) der Folie (2) mittels des Folienmanipulierabschnittes (13) aufweist.

8. Verfahren zum Ablösen einer Folie (2) von einem scheibenförmigen Werkstück (3), insbesondere einem Mold-Wafer (3), mittels einer Vorrichtung (1) nach einem der vorhergehenden Ansprüche, mit folgenden Verfahrensschritten:
horizontales Verfahren der Abziehrolle (12) von einer Parkposition (P1) in eine Aufnahmeposition (A) der Abziehrolle (12), wobei in der Aufnahmeposition (A) der Folienmanipulierabschnitt (13) der Folie (2) zugewandt ist;
Aktivieren des Folienmanipulierabschnittes (13) und vertikales Absenken der Abziehrolle (12) auf die Folie (2);
Anhaften des Abschnittes (14) der Folie (2) an der Abziehrolle (12);
vertikales Abheben der Abziehrolle (12) von dem scheibenförmigen Werkstück (3), wobei der Abschnitt (14) der Folie (2) zumindest abschnittsweise von dem scheibenförmigen Werkstück (3) abgelöst wird;
Rotieren der Abziehrolle (12) um einen vorbestimmten Umschlingungswinkel (α) zum zumindest abschnittsweisen Aufwickeln des Abschnittes (14) der Folie (2) auf der Abziehrolle (12) und gleichzeitiges horizontales Verfahren der Abziehrolle (12) in Richtung der Parkposition (P1), wobei die Folie (2) zunehmend von dem scheibenförmigen Werkstück (3) abgelöst wird;
vertikales Verfahren der Abziehrolle (12) von dem scheibenförmigen Werkstück (3) weg gleichzeitig mit dem horizontalen Verfahren bis in eine horizontale Endposition (V) der Abziehrolle (12);
horizontales Verfahren der Abziehrolle (12) über die Parkposition (P1) hinaus in eine Abstoßposition (P2), wobei die Folie (2) in der Abstoßposition (P2) vollständig von dem scheibenförmigen Werkstück (3) abgelöst ist;
Abwickeln des auf der Abziehrolle (12) aufgewickelten Abschnittes (14) der Folie (2) von der Abziehrolle (12) mittels richtungsumgekehrtem Rotieren der Abziehrolle (12) um einen Winkelabschnitt (ϕ) des vorbestimmten Umschlingungswinkel
(α) derart, dass der Folienmanipulierabschnitt (13) in einer Abwurfstellung positioniert ist; und
Abstoßen der Folie (2) von der Abziehrolle (12) mittels dem Folienmanipulierabschnitt (13).

9. Verfahren nach Anspruch 8,
**dadurch gekennzeichnet, dass**
das Rotieren, das vertikale Verfahren und das horizontale Verfahren der Abziehrolle (12) derart ineinander übergehen, dass die Folie (2) ruckfrei von dem scheibenförmigen Werkstück (3) abgelöst wird.

10. Verfahren nach Anspruch 8 oder 9,
**dadurch gekennzeichnet, dass**
die Folie (2) bei einer vorbestimmten Temperatur, insbesondere bei einer Temperatur von 180°C bis 240°C, von dem scheibenförmigen Werkstück (3) abgelöst wird.

11. Verfahren nach einem der Ansprüche 8 bis 10,
**dadurch gekennzeichnet, dass**
ein über das scheibenförmige Werkstück (3) hinausragender Abschnitt (14) der Folie (2) mittels einer Anblaseinrichtung (27) zum Anhaften des Abschnittes (14) der Folie (2) an der Abziehrolle (12) in Richtung der Abziehrolle (2) geblasen wird.

12. Verfahren nach einem der Ansprüche 8 bis 11,
**dadurch gekennzeichnet, dass**
als Umschlingungswinkel (α) ein Winkel von 180° gewählt wird.

13. Verfahren nach einem der Ansprüche 8 bis 12,
**dadurch gekennzeichnet, dass**
die Werkstückaufnahme (5) der Festspanneinrichtung (4) vor dem Abziehen der Folie (2) um einen Abziehwinkel (β) verdreht wird.

14. Verfahren nach einem der Ansprüche 6 bis 11,
**dadurch gekennzeichnet, dass**
das Abstoßen der Folie (2) von der Abziehrolle (12) in eine Folienentsorgungseinrichtung (30) mittels eines Abstoßsensors (31), insbesondere eines Lichtgitters (31), der Folienentsorgungseinrichtung (30) überwacht wird.

## Claims

1. Apparatus (1) for detaching a film (2) from a disk-shaped workpiece (3), in particular a mould wafer (3), comprising:
- a clamping device (4) for clamping the disk-shaped workpiece (3) in a non-positive manner;
- a removal roller (12) comprising a film-handling portion (13) for non-positively taking up or for expelling a portion (14) of the film (2);
- a movement device (17) for moving the removal roller (12) horizontally and/or vertically with respect to a surface (10) of the clamping device (4); and
- a rotating device (24) for rotating the removal roller (12) about a centre axis (25) of the removal roller (12),
**characterised in that** the film-handling portion (13) is designed as a switchable negative pressure/excess pressure portion (13).

2. Apparatus as claimed in claim 1, **characterised in that** the movement device (17) comprises a horizontal movement element (18) for moving the removal roller (12) horizontally with respect to the surface (10) of the clamping device (4) and comprises a vertical movement element (21) for moving the removal roller (12) vertically with respect to the surface (10) of the clamping device (4).

3. Apparatus as claimed in claim 1 or 2, **characterised in that** the apparatus (1) comprises a heating device (26) for heating the disk-shaped workpiece (3) and/or the film (2) to a predetermined temperature, in particular to a temperature between 180 °C and 240 °C.

4. Apparatus as claimed in any one of the preceding claims, **characterised in that** the clamping device (4) comprises a drive element (6) for rotating a workpiece receiver (5) of the clamping device (4) about an axis of rotation (7) of the workpiece receiver (5).

5. Apparatus as claimed in any one of the preceding claims, **characterised in that** the apparatus (1) comprises a blowing device (27) for blowing a portion (14) of the film (2) projecting beyond the disk-shaped workpiece (3), wherein the blowing device (27) is designed such that it blows the projecting portion (14) in the direction of the removal roller (12).

6. Apparatus as claimed in any one of the preceding claims, **characterised in that** the film-handling portion (13) of the removal roller (12) is designed as a suction/blowing nozzle (13) or as a suction/blowing slot (13), which is arranged along the centre axis (25) of the removal roller (12), for non-positively taking up the portion (14) of the film (2) by means of a negative pressure or for expelling the portion (14) of the film (2) by means of an excess pressure.

7. Apparatus as claimed in any one of the preceding claims, **characterised in that** the removal roller (12) comprises an adhesion sensor (15), in particular a vacuum switch (15), to establish the non-positive take-up or expulsion of the portion (14) of the film (2) by means of the film-handling portion (13).

8. Method for detaching a film (2) from a disk-shaped workpiece (3), in particular a mould wafer (3), by means of an apparatus (1) as claimed in any one of the preceding claims, comprising the following method steps:
- moving the removal roller (12) horizontally from a parking position (P1) to a take-up position (A) of the removal roller (12), wherein the film-handling portion (13) faces towards the film (2) in the take-up position (A); activating the film-handling portion (13) and lowering the removal roller (12) vertically onto the film (2) ;
- adhering the portion (14) of the film (2) to the removal roller (12);
- raising the removal roller (12) vertically from the disk-shaped workpiece (3), wherein the portion (14) of the film (2) is detached at least in sections from the disk-shaped workpiece (3);
- rotating the removal roller (12) by a predetermined wrap angle (α) to wind up at least sections of the portion (14) of the film (2) on the removal roller (12) and simultaneously moving the removal roller (12) horizontally in the direction of the parking position (P1), wherein the film (2) is detached progressively from the disk-shaped workpiece (3);
- moving the removal roller (12) vertically away from the disk-shaped workpiece (3) simultaneously with the horizontal movement as far as to a horizontal end position (V) of the removal roller (12) ;
- moving the removal roller (12) horizontally beyond the parking position (P1) to an expulsion position (P2), wherein the film (2) is completely detached from the disk-shaped workpiece (3) in the expulsion position (P2);
- unwinding the portion (14) of the film (2), which is wound onto the removal roller (12), from the removal roller (12) by rotating the removal roller (12) in the opposite direction by an angular portion (ϕ) of the predetermined wrap angle (α) such that the film-handling portion (13) is positioned in a discharge position; and
- expelling the film (2) from the removal roller (12) by means of the film-handling portion (13).

9. Method as claimed in claim 8, **characterised in that** the rotation, the vertical movement and the horizontal movement of the removal roller (12) merge into one another such that the film (2) is detached smoothly from the disk-shaped workpiece (3).

10. Method as claimed in claim 8 or 9, **characterised in that** the film (2) is detached from the disk-shaped workpiece (3) at a predetermined temperature, in particular at a temperature of 180 °C to 240 °C.

11. Method as claimed in any one of claims 8 to 10, **characterised in that** a portion (14) of the film (2) which projects beyond the disk-shaped workpiece (3) is blown in the direction of the removal roller (2) by means of a blowing device (27) for adhering the portion (14) of the film (2) to the removal roller (12).

12. Method as claimed in any one of claims 8 to 11, **characterised in that** an angle of 180º is selected as the wrap angle (α).

13. Method as claimed in any one of claims 8 to 12, **characterised in that** the workpiece receiver (5) of the clamping device (4) is rotated by a removal angle (β) before the film (2) is removed.

14. Method as claimed in any one of claims 6 to 11, **characterised in that** the expulsion of the film (2) from the removal roller (12) into a film disposal device (30) is monitored by means of an expulsion sensor (31), in particular by a light grid (31), of the film disposal device (30).

## Revendications

1. Dispositif (1) pour le décollement d'un film (2) d'une pièce en forme de disque (3), en particulier d'une tranche moulée (3), comprenant :
- un moyen de serrage (4) pour le serrage à force de la pièce en forme de disque (3) ;
- un rouleau de décollement (12) comprenant une section de manipulation de film (13) pour la réception à force ou pour l'éjection d'une section (14) du film (2) ;
- un moyen de déplacement (17) pour le déplacement du rouleau de décollement (12), horizontalement et/ou verticalement, par rapport à une surface (10) du moyen de serrage (4) ; et
- un moyen de rotation (24), pour la rotation du rouleau de décollement (12) autour d'un axe médian (25) du rouleau de décollement (12), **caractérisé par le fait que** la section de manipulation de film (13) est réalisée comme section de dépression/surpression commutable (13).

2. Dispositif selon la revendication 1, **caractérisé par le fait que** le moyen de déplacement (17) présente un élément de déplacement horizontal (18) pour déplacer le rouleau de décollement (12) horizontalement par rapport à la surface (10) du moyen de serrage (4) et un élément de déplacement vertical (21) pour le déplacement du roulement de décollement (12) verticalement par rapport à la surface (10) du moyen de serrage (4).

3. Dispositif selon la revendication 1 ou 2, **caractérisé par le fait que** le dispositif (1) présente un moyen de chauffage (26) pour chauffer la pièce en forme de disque (3) et/ou le film (2) à une température prédéterminée, en particulier à une température entre 180 °C et 240 °C.

4. Dispositif selon l'une des revendications précédentes, **caractérisé par le fait que** le moyen de serrage (4) présente un élément d'entraînement (6) pour faire tourner un logement de pièce (5) du moyen de serrage (4) autour d'un axe de rotation (7) du logement de pièce (5).

5. Dispositif selon l'une des revendications précédentes, **caractérisé par le fait que** le dispositif (1) présente un moyen de soufflage (27) pour le soufflage d'une section (14) du film (2) faisant saillie sur la pièce en forme de disque (3), le moyen de soufflage (27) étant réalisé de telle manière que ce dernier souffle la section (14) en saillie en direction du rouleau de décollement (12).

6. Dispositif selon l'une des revendications précédentes, **caractérisé par le fait que** la section de manipulation de film (13) du rouleau de décollement (12) est réalisée sous la forme de buse soufflante/aspirante (13) ou de fente soufflante/aspirante (13) disposée le long d'un axe médian (25) du rouleau de décollement (12) pour la réception à force de la section (14) du film (2) au moyen d'une dépression ou pour l'éjection de la section (14) du film (2) au moyen d'une surpression.

7. Dispositif selon l'une des revendications précédentes, **caractérisé par le fait que** le rouleau de décollement (12) présente un capteur d'adhérence (15), en particulier un interrupteur à vide (15), pour détecter la réception à force ou l'éjection de la section (14) du film (2) au moyen de la section de manipulation de film (13).

8. Procédé pour le décollement d'un film (2) d'une pièce en forme de disque (3), en particulier d'une tranche moulée (3), au moyen d'un dispositif (1) selon l'une des revendications précédentes, comprenant les étapes de procédé suivantes :
- déplacement horizontal du rouleau de décollement (12) d'une position de repos (P1) à une position de logement (A) du rouleau de décollement (12), la section de manipulation de film (13) faisant, dans la position de logement (A), face au film (2) ;
- activation de la section de manipulation de film (13) et abaissement vertical du rouleau de décollement (12) sur le film (2) ;
- adhérence de la section (14) du film (2) sur le rouleau de décollement (12) ;
- soulèvement vertical du rouleau de décollement (12) de la pièce en forme de disque (3), la section (14) du film (2) étant décollée au moins par sections de la pièce en forme de disque (3) ;
- rotation du rouleau de décollement (12) d'un angle d'embrassement (α) prédéterminé pour l'enroulement au moins par sections de la section (14) du film (2) sur le rouleau de décollement (12) et déplacement simultané horizontal du rouleau de décollement (12) en direction de la position de repos (P1), le film (2) étant progressivement décollé de la pièce en forme de disque (3),
- déplacement vertical du rouleau de décollement (12) en éloignement de la pièce en forme de disque (3) en même temps que le déplacement horizontal jusqu'à une position finale horizontale (V) du rouleau de décollement (12) ;
- déplacement horizontal du rouleau de décollement (12) au-delà de la position de repos (P1) jusqu'à une position d'éjection (P2), le film (2) étant complètement décollé, dans la position d'éjection (P2), de la pièce en forme de disque (3) ;
- déroulement de la section (14) du film (2) enroulée sur le rouleau de décollement (12) du rouleau de décollement (12) au moyen d'une rotation dans le sens inverse du rouleau de décollement (12) autour d'une section angulaire (ϕ) de l'angle d'embrassement (α) prédéterminé de telle manière que la section de manipulation de film (13) est positionnée dans une position de dégagement ; et
- éjection du film (2) du rouleau de décollement (12) au moyen de la section de manipulation de film (13).

9. Procédé selon la revendication 8, **caractérisé par le fait que** la rotation, le déplacement vertical et le déplacement horizontal du rouleau de décollement (12) se mêlent de telle manière que le film (2) est décollé sans à-coups de la pièce en forme de disque (3),

10. Procédé selon la revendication 8 ou 9, **caractérisé par le fait que** le film (2) est décollé de la pièce en forme de disque (3) à une température prédéterminée, en particulier à une température de 180 °C à 240 °C.

11. Procédé selon l'une des revendications 8 à 10, **caractérisé par le fait qu'**une section (14) du film (2) faisant saillie sur l'élément en forme de disque (3) est soumise à un soufflage au moyen d'un moyen de soufflage (27) pour faire adhérer la section (14) du film (2) sur le rouleau de décollement (12) en direction du rouleau de décollement (2).

12. Procédé selon l'une des revendications 8 à 11, **caractérisé par le fait qu'**un angle de 180° est choisi comme angle d'embrassement (α).

13. Procédé selon l'une des revendications 8 à 12, **caractérisé par le fait que** le logement de pièce (5) du moyen de serrage (4) est tourné, avant le décollement du film (2), d'un angle de décollement (β).

14. Procédé selon l'une des revendications 6 à 11, **caractérisé par le fait que** l'éjection du film (2) du rouleau de décollement (12) dans un moyen d'évacuation de film (30) est surveillée au moyen d'un capteur d'éjection (31), en particulier d'une barrière lumineuse (31), du moyen d'évacuation de film (30).
